# FASCICULE DE BREVET EUROPEEN

(11) **EP 0 650 046 B1**
(45) Date de publication et mention de la délivrance du brevet: **07.07.1999**
(21) Numéro de dépôt: 94402387.8
(22) Date de dépôt: 24.10.1994
(51) Int. Cl.: G01N 22/00, G01R 27/06

(54) **Dispositif compact et portable pour mesurer le coefficient de réflexion d'une structure exposée à un rayonnement hyperfréquence**
Kompakte und tragbare Vorrichtung zur Messung des Reflektionskoeffizienten einer mit Mikrowellen bestrahlten Struktur
Portable and compact device to measure the reflection coefficient of a structure subjected to microwave radiation

(30) Priorité: 25.10.1993 FR 9312685
(43) Date de publication de la demande: 26.04.1995
(73) Titulaire: AEROSPATIALE Société Nationale Industrielle, 75781 Paris Cédex 16 (FR)
(72) Inventeur: Piau, Gérard Pascal, F-92800 Puteaux (FR)
(74) Mandataire: Dubois-Chabert, Guy

(56) Documents cités:
- WO-A-91/10899
- US-A- 3 025 463
- US-A- 3 936 736

## Description

L'invention concerne un dispositif permettant de mesurer le coefficient de réflexion d'une structure telle qu'une structure composite ou monolithique non métallique, lorsque cette structure est exposée à un rayonnement hyperfréquence.

Un tel dispositif de mesure peut notamment être utilisé afin de vérifier la transparence radioélectrique d'une structure telle que la structure d'un radôme protégeant un radar embarqué sur un aéronef. D'autres applications de ce dispositif peuvent toutefois être envisagées sans sortir du cadre de l'invention.

Les radômes qui assurent la protection des radars équipant les aéronefs peuvent subir, au sol comme en vol, des chocs susceptibles de les endommager. Ils peuvent notamment être heurtés par un engin lorsqu'ils se trouvent au sol. Ils peuvent aussi être heurtés par des oiseaux ou par la foudre quand l'aéronef est en vol.

Les radômes endommagés font l'objet de réparations visant à leur rendre leur intégrité. Cependant, si ces réparations rendent aux radômes leur intégrité mécanique, elles entraînent parfois une modification de la transparence au rayonnement émis par le radar dans la zone réparée. Cette modification peut se traduire par une erreur sur la position et/ou la distance d'un obstacle, ou, à l'extrême, par la non détection d'un obstacle.

Il est donc souhaitable de pouvoir disposer d'un dispositif de mesure permettant de contrôler la transparence radioélectrique des radômes après que ceux-ci aient été réparés. Un tel dispositif pourrait en outre être utilisé afin de contrôler la transparence radioélectrique des radômes neufs lors de leur fabrication.

Pour effectuer de telles mesures, il est connu d'utiliser une chambre anéchoïque dans laquelle on introduit le radôme. Cependant, il s'agit d'une procédure lourde et coûteuse qui ne permet pas d'effectuer le contrôle en atelier ou sur le terrain.

On connaît également des dispositifs de mesure utilisés en laboratoire, connus sous le nom d'analyseurs de réseaux vectoriels, qui permettent de déterminer simultanément l'amplitude et la phase du coefficient de réflexion d'une structure exposée à un rayonnement hyperfréquence.

Ces dispositifs, qui fonctionnent dans une large gamme de fréquences, sont lourds (15 à 20 kg) et encombrants. Ils se prêtent donc mal à une utilisation en atelier ou sur le terrain.

De plus, du fait de l'encombrement et du poids d'un tel dispositif, l'applicateur hyperfréquence servant à émettre le rayonnement hyperfréquence vers la structure à contrôler et à recevoir les ondes réfléchies par cette structure, doit être dissocié du reste du dispositif et relié à celui-ci par un cordon hyperfréquence aussi souple que possible et de longueur suffisante pour que l'on puisse déplacer l'applicateur hyperfréquence sur toute la surface de la structure à contrôler. Cependant, ce cordon hyperfréquence est source de problèmes car il comporte à ses extrémités des connecteurs fragiles et toute torsion appliquée à ce cordon provoque des distorsions de la phase des signaux hyperfréquence qu'il transmet. Les mesures effectuées peuvent, de ce fait, être entachées d'erreurs parfois importantes sur la phase du signal.

Le document US-A-3 025 463 décrit un dispositif permettant de mesurer l'amplitude et la phase du coefficient de réflexion d'une structure à contrôler.

Dans la première forme de réalisation décrite, il s'agit d'un dispositif portable qui comprend un générateur haute fréquence unique relié directement par un guide d'ondes à un applicateur haute fréquence. Dans le guide d'ondes, une partie de l'onde incidente et une partie de l'onde réfléchie sont prélevées pour être acheminées jusqu'à un mélangeur qui en calcule la différence. Des systèmes de réglage manuels permettent de modifier l'amplitude de la fraction de l'onde incidente dirigée vers le mélangeur et la phase de la fraction de l'onde réfléchie dirigée vers ce même mélangeur. Ces réglages sont effectués de façon à annuler le signal reçu par le détecteur. Les valeurs correspondantes sont alors représentatives de l'amplitude et de la phase du coefficient de réflexion de la structure. Si ce dispositif est totalement portable, sa mise en oeuvre est particulièrement longue et évidemment inadaptée à un contrôle industriel.

Dans la deuxième forme de réalisation décrite dans le document US-A-3 025 463, le dispositif de mesure est équipé d'un circuit additionnel permettant d'annuler de façon automatique le signal reçu par le détecteur. Cependant, il s'agit d'un dispositif sensiblement plus lourd et plus volumineux, qui comprend une partie fixe et une partie mobile reliées l'une à l'autre par un câble. Ce câble sert à véhiculer des signaux électriques mais aussi des rayonnements hyperfréquence, de telle sorte qu'on retrouve ici les inconvénients dus à la présence d'un cordon hyperfréquence souple et relativement long, déjà signalés dans le cas des analyseurs de réseaux vectoriels.

L'invention a précisément pour objet un dispositif permettant de mesurer à la fois l'amplitude et la phase du coefficient de réflexion d'une structure exposée à un rayonnement hyperfréquence, en évitant toute erreur sur la phase et sans pénaliser la facilité de manutention et d'utilisation à des fins industrielles.

Conformément à l'invention, ce résultat est obtenu au moyen d'un dispositif de mesure du coefficient de réflexion d'une structure exposée à un rayonnement hyperfréquence, comprenant :
- un premier générateur de rayonnement hyperfréquence, émettant à une première fréquence donnée ;
- au moins un applicateur hyperfréquence apte à être plaqué sur la structure ;
- une ligne rigide de transmission hyperfréquence reliant le générateur à l'applicateur ;
- des moyens de mesure de l'amplitude et de la phase du coefficient de réflexion ;
- des moyens de dérivation placés dans la ligne de transmission et reliant celle-ci aux moyens de mesure ;
caractérisé par le fait qu'il comprend de plus :
- un deuxième générateur de rayonnement hyperfréquence, émettant à une deuxième fréquence donnée, qui diffère de la première fréquence fixe d'une basse fréquence donnée ;
- des premiers moyens mélangeurs, pour établir un signal de référence à ladite basse fréquence, à partir de signaux issus des premier et deuxième générateurs ;
- des deuxièmes moyens mélangeurs, pour établir un signal de mesure à ladite basse fréquence, à partir de signaux issus des moyens de dérivation et du deuxième générateur ;
et par le fait que les premier et deuxième générateurs, l'applicateur hyperfréquence, les premiers et deuxièmes moyens mélangeurs, les moyens de dérivation et la ligne de transmission hyperfréquence forment un dispositif portable, relié aux moyens de mesure par des câbles souples basse fréquence.

Les appareils montés sur le dispositif portable permettent de transformer le signal de référence hyperfréquence issu du premier générateur de rayonnement hyperfréquence ainsi que le signal de mesure hyperfréquence réfléchi par la structure à contrôler en signaux basse fréquence. Ces signaux basse fréquence sont transmis aux moyens de mesure par deux câbles souples basse fréquence dont la torsion éventuelle est sans incidence sur la précision des mesures et notamment sur la phase du signal mesuré, quelle que soit la longueur des câbles. On réalise ainsi des mesures fiables et reproductibles.

De plus, les appareils montés sur le dispositif portable sont des appareils légers et peu encombrants qui rendent ce dispositif portable aisé à manipuler et favorisent, par conséquent, une utilisation industrielle du dispositif de mesure, notamment dans le cadre du contrôle des radômes neufs ou ayant subi des réparations.

Dans une forme de réalisation préférentielle de l'invention, le dispositif portable comprend de plus :
- un premier diviseur de puissance placé sur la ligne de transmission hyperfréquence, en amont des moyens de dérivation, prélevant une fraction de puissance déterminée du rayonnement hyperfréquence émis par le premier générateur, pour la transmettre aux premiers moyens mélangeurs ; et
- un deuxième diviseur de puissance placé sur une deuxième ligne de transmission hyperfréquence reliant le deuxième générateur aux deuxièmes moyens mélangeurs et prélevant la même fraction de puissance déterminée du rayonnement hyperfréquence émis par le deuxième générateur pour la transmettre aux premiers moyens mélangeurs.

De préférence, les diviseurs de puissance prélèvent la moitié de la puissance des rayonnements hyperfréquence émis par le premier et le deuxième générateurs.

Dans la forme de réalisation préférentielle de l'invention, les moyens de dérivation comprennent un circulateur assurant la transmission à l'applicateur hyperfréquence du rayonnement hyperfréquence en provenance du premier générateur et la transmission au deuxième moyen mélangeur du rayonnement hyperfréquence réfléchi par la structure et capté par l'applicateur hyperfréquence, et interdisant toute autre transmission.

Afin d'améliorer la compacité du dispositif portable, l'applicateur hyperfréquence est de préférence connecté directement sur les moyens de dérivation.

Avantageusement, les moyens de mesure comprennent des moyens de détection qui déterminent l'amplitude et la phase du coefficient de réflexion. Ces moyens de détection peuvent être constitués par un voltmètre vectoriel ou par un détecteur d'amplitude et de phase, appelé communément détecteur I/Q. De plus, lesdits moyens de mesure comprennent des moyens d'enregistrement et d'exploitation de l'amplitude et de la phase déterminées par les moyens de détection.

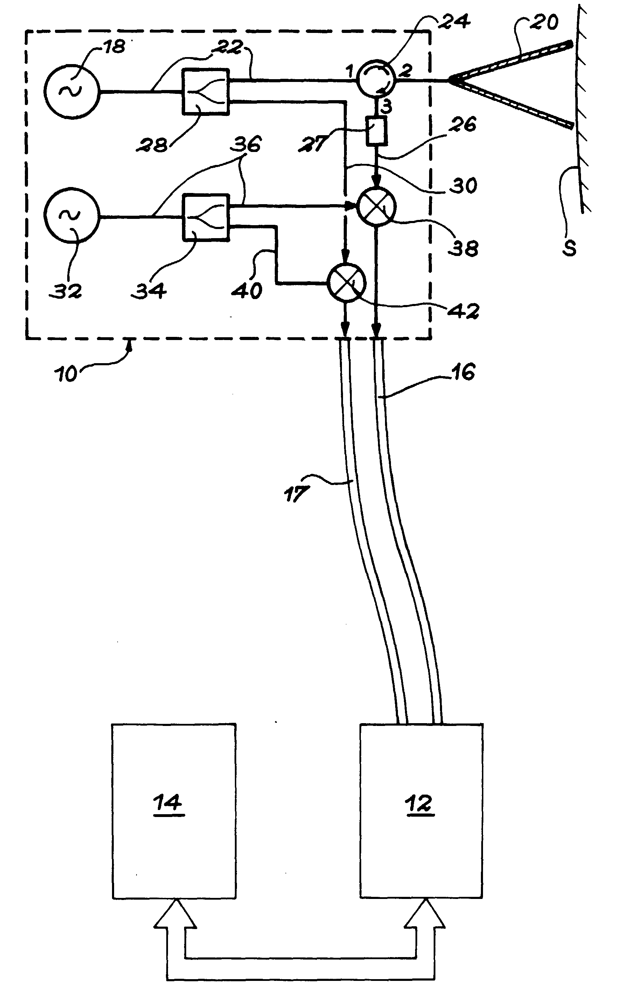

On décrira à présent, à titre d'exemple non limitatif, une forme de réalisation préférentielle de l'invention, en se référant aux dessins annexés, dans lesquels la figure unique représente schématiquement un dispositif conforme à l'invention, apte à mesurer le coefficient de réflexion d'une structure exposée à un rayonnement hyperfréquence.

Comme l'illustre schématiquement la figure unique, le dispositif de mesure selon l'invention comprend un dispositif portable 10 ainsi que des moyens de mesure incluant des moyens de détection 12 tels qu'un voltmètre vectoriel ou un détecteur I/Q, et des moyens 14 d'enregistrement et d'exploitation des informations délivrées par les moyens de détection 12. Le dispositif portable 10 est relié aux moyens de détection 12 par des câbles souples basse fréquence 16 et 17, dont la longueur peut être quelconque.

Le dispositif portable 10 inclut un premier générateur 18 de rayonnement hyperfréquence constitué par exemple par un oscillateur hyperfréquence apte à émettre un rayonnement hyperfréquence. La fréquence f₁ de ce rayonnement dépend de la structure S dont on désire effectuer le contrôle. Dans le cas où cette structure est constituée par un radôme de protection d'un radar, cette fréquence f₁ sera avantageusement la fréquence du radar, c'est-à-dire, par exemple, une fréquence d'environ 9 à 10 GHz.

Le premier générateur 18 de rayonnement hyperfréquence est relié par une ligne de transmission hyperfréquence 22 à un applicateur hyperfréquence constitué par exemple par un cornet hyperfréquence 20 monté sur le dispositif portable 10. La ligne de transmission hyperfréquence 22 est constituée par un guide d'ondes de très petite longueur ou une ligne coaxiale rigide.

Sur la ligne de transmission hyperfréquence 22, le rayonnement hyperfréquence est transmis du premier générateur 18 au cornet hyperfréquence 20 au travers de moyens de dérivation constitués par exemple par un circulateur 24.

De façon plus précise, le circulateur 24 permet de transmettre en totalité à sa sortie 2, sur laquelle est raccordé le cornet hyperfréquence 20, le rayonnement hyperfréquence admis à son entrée 1, sur laquelle est raccordé le premier générateur 18, et de transmettre en totalité à sa sortie 3, sur laquelle est raccordée une ligne de mesure hyperfréquence 26, le rayonnement hyperfréquence qui lui parvient par la sortie 2, tout en interdisant toute autre transmission. La ligne de mesure hyperfréquence 26 est équipée d'un atténuateur hyperfréquence 27. Le rayonnement hyperfréquence réfléchi par la structure S et capté par le cornet hyperfréquence 20 constitue un signal de mesure qui est donc renvoyé par le circulateur 24 dans la ligne de mesure hyperfréquence 26 et l'atténuateur hyperfréquence 27.

Afin de réduire autant que possible la longueur de la ligne de transmission hyperfréquence 22, le cornet hyperfréquence 20 est connecté directement sur le circulateur 24.

Un premier diviseur de puissance 28 est également placé sur la ligne de transmission hyperfréquence 22 entre le premier générateur 18 et le circulateur 24. Ce premier diviseur de puissance 28 permet de prélever une fraction de la puissance du rayonnement hyperfréquence émis par le premier générateur 18, pour la diriger dans une ligne de référence hyperfréquence 30. Cette fraction du rayonnement hyperfréquence émise par le générateur 18 et dirigée vers la ligne de référence hyperfréquence 30 constitue un signal de référence auquel peut être comparé le signal de mesure capté par le cornet hyperfréquence 20 et dirigé vers la ligne de mesure hyperfréquence 26 par le circulateur 24. Avantageusement, le diviseur de puissance 28 prélève la moitié de la puissance du rayonnement hy-perfréquence émis par le premier générateur 18, pour la diriger vers la ligne de référence hyperfréquence 30.

Conformément à l'invention, le dispositif portable 10 comporte de plus des moyens permettant de transformer en signaux basse fréquence les signaux hyperfréquences que constituent le signal de mesure admis dans la ligne de dérivation hyperfréquence 26 et le signal de référence admis dans la ligne hyperfréquence 30. Plus précisément, ces moyens permettent de transformer le signal de mesure hyperfréquence et le signal de référence hyperfréquence en signaux dont la fréquence f₀ est suffisamment basse pour qu'ils puissent être transportés par les câbles souples 16 et 17 sans risque de distorsion de leur phase du fait d'une torsion de ce câble. A cet effet, une fréquence f₀ comprise entre 60 et 200 MHz est satisfaisante.

Les moyens précités, assurant la transformation du signal de mesure et du signal de référence en signaux basse fréquence, comprennent un deuxième générateur 32 de rayonnement hyperfréquence, également constitué par un oscillateur hyperfréquence monté dans le dispositif portable 10. Ce deuxième générateur 32 émet un rayonnement hyperfréquence à une fréquence donnée f₂ égale à la fréquence f₁ du rayonnement émis par le premier générateur 18, augmentée ou diminuée d'une basse fréquence f₀ donnée, correspondant à la basse fréquence des signaux que l'on désire transmettre par les câbles souples 16 et 17. La fréquence f₂ du rayonnement hyperfréquence émis par le deuxième générateur 32 est donc égale à f₁ ± f₀.

Le rayonnement hyperfréquence émis par le deuxième générateur 32 est véhiculé par une deuxième ligne de transmission hyperfréquence 36. Un deuxième diviseur de puissance 34, placé dans cette deuxième ligne de transmission 36, prélève une fraction de puissance déterminée, identique à celle prélevée par le premier diviseur de puissance 28, du rayonnement hyperfréquence émis par le deuxième générateur 32. Cette fraction de puissance est donc avantageusement égale à la moitié de la puissance du rayonnement émis par le deuxième générateur 32.

La ligne de mesure hyperfréquence 26 ainsi que la deuxième ligne de transmission hyperfréquence 36 sont raccordées sur des premiers moyens mélangeurs hyperfréquence 38, à l'intérieur du dispositif portable 10. Afin d'optimiser le fonctionnement des premiers moyens mélangeurs 38 la ligne hyperfréquence 26 est équipée de l'atténuateur hyperfréquence 27. Ces premiers moyens mélangeurs 38 reçoivent donc le signal de mesure hyperfréquence, à la fréquence f₁, en provenance de la ligne de mesure hyperfréquence 26, et le signal hyperfréquence à la fréquence f₂ en provenance de la ligne hyperfréquence 36. Les moyens mélangeurs 38 restituent à leur sortie un signal dont l'amplitude et la phase sont proportionnelles au signal de mesure mais dont la fréquence est égale à la différence entre les fréquences f₂ et f₁. Le signal de mesure issu des moyens mélangeurs 38 est donc un signal à la fréquence f₀, c'est-à-dire un signal basse fréquence. Par conséquent, ce signal basse fréquence peut être transmis aux moyens de détection 12 par le câble souple 16 sans risque d'erreur sur la phase du fait d'une torsion de ce câble, même si celui-ci est de grande longueur.

D'une manière comparable, la ligne de référence hyperfréquence 30 ainsi que la ligne hyperfréquence 40 issue des moyens de dérivation 34 sont raccordées sur des deuxièmes moyens mélangeurs hyper-fréquence 42, à l'intérieur du dispositif portable 10. Ces moyens mélangeurs 42 ont les mêmes caractéristiques que les moyens mélangeurs 38. Cela signifie qu'ils restituent à leur sortie un signal de référence dont l'amplitude et la phase sont proportionnelles au signal de référence hyperfréquence circulant dans la ligne de référence hyperfréquence 30, mais dont la fréquence est égale à la fréquence f₀. Le signal de référence sortant des moyens mélangeurs 42 est donc un signal basse fréquence qui peut, lui aussi, être acheminé jusqu'aux moyens de détection 12 par le câble souple 17 sans risque d'erreur sur sa phase malgré une éventuelle torsion de ce câble.

Les moyens de détection 12, qui reçoivent les signaux basse fréquence de mesure et de référence transmis par les câbles souples 16 et 17, déterminent, à partir de ces signaux et d'une manière connue, l'amplitude et la phase du coefficient de réflexion de la structure S. Lorsque les moyens de détection 12 sont constitués par un voltmètre vectoriel, celui-ci comporte avantageusement un écran sur lequel sont affichées les valeurs de l'amplitude et de la phase ainsi déterminées.

Les moyens 14 d'enregistrement et d'exploitation des valeurs déterminées par les moyens de détection 12 comprennent un calculateur. Ce calcula-teur enregistre les valeurs mesurées de l'amplitude et de la phase. Il assure en outre, à l'aide d'un logiciel approprié, le traitement et l'interprétation de ces valeurs, pour les présenter sous une forme aisément exploitable.

Lors de la mise en oeuvre du dispositif selon l'invention, on procède successivement à un calibrage de l'appareillage, à une première mesure avec un réflecteur placé sur la face opposée de la structure à contrôler et à une deuxième mesure en remplaçant le réflecteur par une charge absorbant les micro-ondes.

Le calibrage est effectué en plaçant directement le cornet hyperfréquence 20 devant le réflecteur.

Le réflecteur, constitué par exemple par une feuille métallique, est ensuite plaqué sur la face opposée de la structure. Cela peut notamment être obtenu en créant un joint périphérique étanche entre le réflecteur et la structure, à l'aide de mastic, et en faisant le vide dans la zone étanche ainsi formée entre le réflecteur et la structure à contrôler.

La mesure en présence du réflecteur est ensuite effectuée en plaçant le cornet hyperfréquence 20 devant la région concernée de la structure.

Le réflecteur est ensuite retiré et remplacé par une feuille constituant la charge absorbant les micro-ondes. Cette feuille est mise en place de la même manière que le réflecteur, c'est-à-dire par dépression.

La mesure en présence de la charge est alors réalisée en replaçant le cornet hyperfréquence 20 devant la région concernée.

Dans le cas où le contrôle concerne une région réparée d'un radôme, on effectue successivement les mesures en présence d'un réflecteur et en présence d'une charge dans cette région réparée. Les mêmes mesures sont aussi effectuées dans une autre région, non réparée du radôme, ayant sensiblement la même courbure et la même finition de surface que la région réparée.

Le dispositif de mesure selon l'invention permet ainsi de faire un contrôle sur site, sans distorsion de la composante phase du signal, conformément à l'objectif visé.

## Revendications

1. Dispositif de mesure du coefficient de réflexion d'une structure exposée à un rayonnement hyperfréquence, comprenant :
- un premier générateur (18) de rayonnement hyperfréquence, émettant à une première fréquence donnée (f₁);
- au moins un applicateur hyperfréquence (20) apte à être plaqué sur la structure ;
- une ligne rigide de transmission hyperfréquence (22) reliant le générateur à l'applicateur ;
- des moyens de mesure (12,14) de l'amplitude et de la phase du coefficient de réflexion ;
- des moyens de dérivation (24) placés dans la ligne de transmission et reliant celle-ci aux moyens de mesure ;
caractérisé par le fait qu'il comprend de plus :
- un deuxième générateur (32) de rayonnement hyperfréquence, émettant à une deuxième fréquence donnée qui diffère de la première fréquence fixe (f₁) d'une basse fréquence (f₀) donnée ;
- des premiers moyens mélangeurs (42), pour établir un signal de référence à ladite basse fréquence, à partir de signaux issus des premier et deuxième générateurs (18,32);
- des deuxièmes moyens mélangeurs (38), pour établir un signal de mesure à ladite basse fréquence, à partir de signaux issus des moyens de dérivation (24) et du deuxième générateur (32);
et par le fait que les premier et deuxième générateurs (18,32), l'applicateur hyperfréquence (20), les premiers et deuxièmes moyens mélangeurs (42,38), les moyens de dérivation (24) et la ligne de transmission hyperfréquence (22) forment un dispositif portable (10), relié aux moyens de mesure (12,14) par des câbles souples basse fréquence (16,17).

2. Dispositif selon la revendication 1, caractérisé par le fait que le dispositif portable (10) comprend de plus :
- un premier diviseur de puissance (28) placé sur la ligne de transmission hyperfréquence (22), en amont des moyens de dérivation (24), prélevant une fraction de puissance déterminée du rayonnement hyperfréquence émis par le premier générateur (18), pour la transmettre aux premiers moyens mélangeurs (42) ; et
- un deuxième diviseur de puissance (34) placé sur une deuxième ligne de transmission hyperfréquence (36) reliant le deuxième générateur (32) aux deuxièmes moyens mélangeurs (38) et prélevant la même fraction de puissance déterminée du rayonnement hyperfréquence émis par le deuxième générateur (32) pour la transmettre aux premiers moyens mélangeurs (42).

3. Dispositif selon la revendication 2, caractérisé par le fait que ladite fraction de puissance déterminée est égale à la moitié de la puissance des rayonnements hyperfréquence émis par le premier et le deuxième générateurs (18,32).

4. Dispositif selon l'une quelconque des revendications 1 à 3, caractérisé par le fait que les moyens de dérivation comprennent un circulateur (24) assurant la transmission à l'applicateur hyperfréquence du rayonnement hyperfréquence en provenance du premier générateur (18) et la transmission aux deuxièmes moyens mélangeurs (38) du rayonnement hyperfréquence réfléchi par la structure (S) et capté par l'applicateur hyperfréquence (20), et interdisant toute autre transmission.

5. Dispositif selon l'une quelconque des revendications précédentes, caractérisé par le fait que l'applicateur hyperfréquence (20) est connecté directement sur les moyens de dérivation (24).

6. Dispositif selon l'une quelconque des revendications précédentes, caractérisé par le fait que les moyens de mesure comprennent des moyens de détection (12) qui déterminent l'amplitude et la phase du coefficient de réflexion.

7. Dispositif selon la revendication 6, caractérisé par le fait que les moyens de mesure comprennent de plus des moyens (14) d'enregistrement et d'exploitation de l'amplitude et de la phase déterminées par les moyens de détection (12).

## Patentansprüche

1. Vorrichtung zur Messung des Reflexionskoeffizienten einer mit Mikrowellen bestrahlten Struktur, umfassend:
- einen ersten, mit einer bestimmten, ersten Frequenz (fₗ) ausstrahlenden Mikrowellen-Generator (18) ;
- wenigstens eine Mikrowellen-Anwendungseinrichtung (20), die sich dazu eignet, gegen die Struktur gedrückt bzw. gehalten zu werden;
- eine starre Mikrowellen-Übertragungsleitung (22), die den Generator mit der Anwendungseinrichtung verbindet;
- Meßeinrichtungen (12, 14) der Amplitude und der Phase des Reflexionskoeffizienten;
- Verzweigungseinrichtungen (24), die sich in der Übertragungsleitung befinden und diese mit den Meßeinrichtungen verbinden;
**dadurch gekennzeichnet**, daß sie außerdem umfaßt:
- einen zweiten Generator (32), der mit einer bestimmten, zweiten Frequenz ausstrahlt, die von der ersten, festen Frequenz (f₁) um eine bestimmte Niederfrequenz (f₀) abweicht;
- erste Mischeinrichtungen (42), um aufgrund der von dem ersten und zweiten Generator (18,32) stammenden Signale ein Bezugssignal mit der genannten Niederfrequenz herzustellen;
- zweite Mischeinrichtungen (38), um aufgrund der von den Verzweigungseinrichtungen (24) und dem zweiten Generator (32) stammenden Signale ein Meßsignal mit der genannten Niederfrequenz herzustellen;
und dadurch, daß der erste und der zweite Generator (18,32), die Mikrowellen-Anwendungseinrichtung (20), die erste und die zweite Mischeinrichtung (42,38), die Verzweigungseinrichtungen (24) und die Mikrowellen-Übertragungsleitung (22) eine tragbare Vorrichtung (10) bilden, verbunden mit den Meßeinrichtungen (12,14) durch biegsame Niederfrequenzkabel (16,17).

2. Vorrichtung nach Anspruch 1, dadurch gekennzeichnet, daß die tragbare Vorrichtung (10) außerdem umfaßt:
- einen ersten Leistungsteiler (28), angebracht in der Mikrowellen-Übertragungsleitung (22), vor den Verzweigungseinrichtungen (24), der einen bestimmten Teil der durch ersten Generator (18) ausgesandten Mikrowellenstrahlung entnimmt, um ihn zu den ersten Mischeinrichtungen (42) zu übertragen; und
- einen zweiten Leistungsteiler (34), angebracht in einer zweiten Mikrowellen-Übertragungsleitung (36), die den zweiten Generator (32) mit den zweiten Mischeinrichtungen (38) verbindet und der den gleichen bestimmten Teil der Leistung der durch den zweiten Generator (32) ausgesandten Mikrowellenstrahlung entnimmt, um ihn zu den ersten Mischeinrichtungen (42) zu übertragen.

3. Vorrichtung nach Anspruch 2, dadurch gekennzeichnet, daß der genannte bestimmte Teil der Leistung gleich der Hälfte der Leistung der durch den ersten und den zweiten Generator (18,32) ausgesandten Mikrowellenstrahlungen ist.

4. Vorrichtung nach einem der Ansprüche 1 bis 3, dadurch gekennzeichnet, daß die Verzweigungseinrichtungen einen Zirkulator (24) umfassen, der die Übertragung der von dem ersten Generator (18) stammenden Mikrowellenstrahlung zu der Mikrowellen-Anwendungseinrichtung und die Übertragung der durch die Struktur (S) reflektierten und durch die Mikrowellen-Anwendungseinrichtungen (20) aufgefangenen Mikrowellenstrahlung zu den zweiten Mischeinrichtungen (38) sicherstellt und dabei keine andere Übertragung zuläßt.

5. Vorrichtung nach einem der vorangehenden Ansprüche, dadurch gekennzeichnet, daß die Anwendungseinrichtung (20) direkt mit den Verzweigungseinrichtungen (24) verbunden ist.

6. Vorrichtung nach einem der vorangehenden Ansprüche, dadurch gekennzeichnet, daß die Meßeinrichtungen Detektionseinrichtungen (12) umfassen, die die Amplitude und die Phase des Reflexionskoeffizienten bestimmen.

7. Vorrichtung nach Anspruch 6, dadurch gekennzeichnet, daß die Meßeinrichtungen außerdem Aufzeichnungs- und Auswertungseinrichtungen (14) der durch die Detektionseinrichtungen (12) bestimmten Amplitude und Phase umfassen.

## Claims

1. Device for measuring the reflection coefficient of a structure exposed to microwave radiation comprising:
- a first microwave radiation generator (18) emitting at a first given frequency (f₁),
- at least one microwave applicator (20) which can be plated to the structure,
- a rigid microwave transmission line (22) connecting the generator to the applicator,
- means (12, 14) for measuring the amplitude and phase of the reflection coefficient,
- branching means (24) placed in the transmission line and connecting the latter to the measuring means,
characterized in that it also comprises:
- a second microwave radiation generator (32) emitting at a second given frequency, which differs from the first fixed frequency (f₁) by a given low frequency (fₒ),
- first mixer means (42) for establishing a reference signal at said low frequency, on the basis of the signals from the first and second generators (18, 32),
- second mixer means (38) for establishing a measuring signal at said low frequency, on the basis of signals from the branching means (24) and the second generator (32),
and in that the first and second generators (18, 32), the microwave applicator (20), the first and second mixer means (42, 38), the branching means (24) and the microwave transmission line (22) form a portable device (10) connected to the measuring means (12, 14) by flexible, low frequency cables (16, 17).

2. Device according to claim 1, characterized in that the portable device (10) also comprises:
- a first power divider (28) placed on the microwave transmission line (22) upstream of the branching means (24), sampling a given power fraction of the microwave radiation emitted by the first generator (18) in order to transmit it to the first mixer means (42) and
- a second power divider (34) placed on a second microwave transmission line (36) connecting the second generator (32) to the second mixer means (38) and sampling the same given power fraction of the microwave radiation emitted by the second generator (32) in order to transmit it to the first mixer means (42).

3. Device according to claim 2, characterized in that said given power fraction is equal to half the power of the microwave radiations emitted by the first and second generators (18, 32).

4. Device according to any one of the claims 1 to 3, characterized in that the branching means comprise a circulator (24) ensuring the transmission to the microwave applicator of the microwave radiation from the first generator (18) and the transmission to the second mixer means (38) of the microwave radiation reflected by the structure (S) and intercepted by the microwave applicator (20), whilst preventing any other transmission.

5. Device according to any one of the preceding claims, characterized in that the microwave applicator (20) is directly connected to the branching means (24).

6. Device according to any one of the preceding claims, characterized in that the measuring means comprise detection means (12), which determine the amplitude and phase of the reflection coefficient.

7. Device according to claim 6, characterized in that the measuring means also comprise means (14) for recording and exploiting the amplitude and phase determined by the detection means (12).
